# EUROPEAN PATENT APPLICATION

(11) **EP 4 598 326 A1**
(43) Date of publication of application: **06.08.2025**
(21) Application number: 23872984.2
(22) Date of filing: 22.09.2023
(51) Int. Cl.: H10K 71/00, H10K 71/16, C23C 14/04

(54) **METAL PLATE AND DEPOSITION MASK COMPRISING SAME**

(30) Priority: 29.09.2022 KR 20220124332
(71) Applicant: LG INNOTEK CO. LTD, Gangseo-gu Seoul 07796 (KR)
(72) Inventor: KWON, Ki Young, Seoul 07796 (KR)
(74) Representative: Plasseraud IP
(86) International application number: PCT/KR2023/014553
(87) International publication number: WO 2024/071867

(57) **Abstract**

A metal plate according to an embodiment is a metal plate having a length (L) of 900 mm to 1,100 mm, a width (W) of 290 mm to 300 mm, and a thickness (T) of 15 µm to 100 µm, wherein the metal plate includes invar, the thickness of the metal plate is adjusted to a test thickness (X) of 3 µm to 10 µm to form a unit metal plate having a unit size of L*W*X, a number of inclusions per unit size of the unit metal plate is 10 or less, and the inclusion has a size exceeding the test thickness.

## Description

### [Technical Field]

The embodiment relates to a deposition mask for OLED pixel deposition.

### [Background Art]

A display device is applied to various devices. For example, the display device is applied to a small device such as a smartphone or a tablet PC. Alternatively, the display device is applied to a large device such as a TV, a monitor, or a public display (PD). Recently, the demand for ultra-high definition (UHD) with a resolution of 500 PPI (Pixel Per Inch) or higher is increasing. Accordingly, display devices with high resolution are being applied to small devices and large devices.

The display device is classified into a LCD (Liquid Crystal Display) and an OLED (Organic Light Emitting Diode) depending on a driving method.

The LCD is a display device driven using liquid crystal. In addition, OLED is a display device driven using organic matter.

The OLED can achieve an infinite contrast ratio, has a response speed that is 1000 times faster than LCD, and has an excellent viewing angle. Accordingly, the OLED is attracting attention as a display device that can replace the LCD.

The OLED includes a light-emitting layer. The light-emitting layer includes an organic material. The organic material is deposited on a substrate by a deposition mask. The deposition mask may include an open mask (OM) or a fine metal mask (FMM). A deposition pattern corresponding to a pattern formed in the deposition mask is formed on the substrate. Accordingly, the deposition pattern can serve as a pixel.

The open mask is a thin plate that forms a deposition pattern only at a specific location when manufacturing an OLED. The open mask is used in a deposition process for forming a light-emitting layer thereon after a backplane is completed during the display manufacturing process. In other words, the open mask is a mask that does not have a covering region within a range in which the display operates in order to deposit an entire surface of the display. Therefore, the open mask is used when depositing a light-emitting layer with a light-emitting material of one color.

On the other hand, the fine metal mask is used to change a color of a sub-pixel of the light-emitting layer. Therefore, the fine metal mask includes an ultrafine hole. A process using the fine metal mask must perform several stages of deposition. Therefore, the process requires precise alignment. Accordingly, the process using the fine metal mask is more difficult than the process using the open mask.

When the light-emitting layer of the OLED is deposited by the open mask, only one color light-emitting layer is formed. Therefore, a separate color filter (C/F) is required to implement various colors. On the other hand, when the fine metal mask is used, an RGB light-emitting layer can be formed. Therefore, a separate color filter is not required. In other words, a technology using the fine metal mask is more difficult. However, a method using the fine metal mask is more light-efficient as the method using the fine metal mask does not require a filter to block light, unlike the method using an open mask.

The fine metal mask is generally manufactured by an Invar alloy metal plate containing iron (Fe) and nickel (Ni). Through holes are formed on one surface and other surface of the metal plate and penetrates the one surface and the other surface. The through holes are formed at positions corresponding to pixel patterns. Accordingly, red, green, and blue organic materials can pass through the through holes of the metal plate and be deposited on the substrate. Accordingly, pixel patterns can be formed on the substrate.

The fine metal mask can be manufactured using a metal plate made of an iron (Fe)-nickel (Ni) alloy. For example, the deposition mask can be manufactured using invar.

The metal plate can include various impurities such as oxygen, iron element, and sulfur element in addition to iron and nickel. The impurities form crystals inside the metal plate. Accordingly, the impurities can remain as inclusions in the metal plate.

If a size of the inclusion is large, a size of the through hole can be changed by the inclusion. Alternatively, adjacent through holes can be connected by the inclusion. As a result, a deposition quality of the deposition mask can be reduced.

Therefore, an inclusion test method, a metal plate, and a deposition mask that can solve the above problems are required.

### [Disclosure]

### [Technical Problem]

An embodiment provides a deposition mask having reduced defects in through holes.

The embodiment provides a deposition mask having improved uniformity in through holes.

### [Technical Solution]

A metal plate according to an embodiment is a metal plate having a length (L) of 900 mm to 1,100 mm, a width (W) of 290 mm to 300 mm, and a thickness (T) of 15 µm to 100 µm, wherein the metal plate includes invar, the thickness of the metal plate is adjusted to a test thickness (X) of 3 µm to 10 µm to form a unit metal plate having a unit size of L*W*X, a number of inclusions per unit size of the unit metal plate is 10 or less, and the inclusion has a size exceeding the test thickness.

### [Advantageous Effects]

The metal plate according to the embodiment can control a number of inclusions. Specifically, a number of inclusions having a size greater than or equal to a set size in a unit metal plate of unit size is controlled.

The metal plate controls a DPU (Defect Per Unit) of the unit metal plate within a set range. Therefore, a defect of the through hole of the deposition mask manufactured through the unit metal plate is reduced. Therefore, the deposition mask has improved deposition quality and deposition reliability.

In addition, a normality and a defect of the unit metal plate can be checked in advance before manufacturing the deposition mask. Therefore, a process of manufacturing the deposition mask with a defective unit metal plate can be prevented. Therefore, process efficiency is improved.

In addition, a number of inclusions having a size greater than or equal to a set size in a unit size specimen can be controlled.

Accordingly, the DPU (Defect Per Unit) of the deposition mask is controlled within a set range. Therefore, the defect of the through hole is reduced. Therefore, the deposition mask has improved deposition quality and deposition reliability.

In addition, after manufacturing the deposition mask, the deposition quality and deposition reliability of the deposition mask can be confirmed in advance through a size of the DPU (Defect Per Unit). Therefore, only the deposition mask with a small defect rate of the through hole can be selectively selected. Therefore, the efficiency of a deposition process is improved.

### [Description of Drawings]

FIGS. 1 to 10 are drawings for explaining a test method of a metal plate according to an embodiment.
FIGS. 11 and 12 are photographs of experimental examples.
FIG. 13 is a drawing illustrating a combination of a deposition mask and a frame according to an embodiment.
FIG. 14 is a cross-sectional view of an organic deposition device including a deposition mask according to an embodiment.
FIG. 15 is a drawing illustrating a deposition pattern being formed on a deposition substrate by a through hole of a deposition mask according to an embodiment.
FIG. 16 is a plan view of a deposition mask according to an embodiment.
FIG. 17 is a drawing for explaining a defect in a through hole in a deposition mask according to an embodiment.

### [Best Mode]

Hereinafter, embodiments will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and redisposed. In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

Further, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

The deposition mask described below is a fine metal mask (FMM) capable of depositing red, green, and blue organic materials on a deposition substrate to form an RGB pixel pattern on the deposition substrate. In addition, the following description does not apply to an open mask (OM).

In the following description, a first direction is a length direction of the metal plate or deposition mask. In addition, a second direction is a width direction of the metal plate or deposition mask.

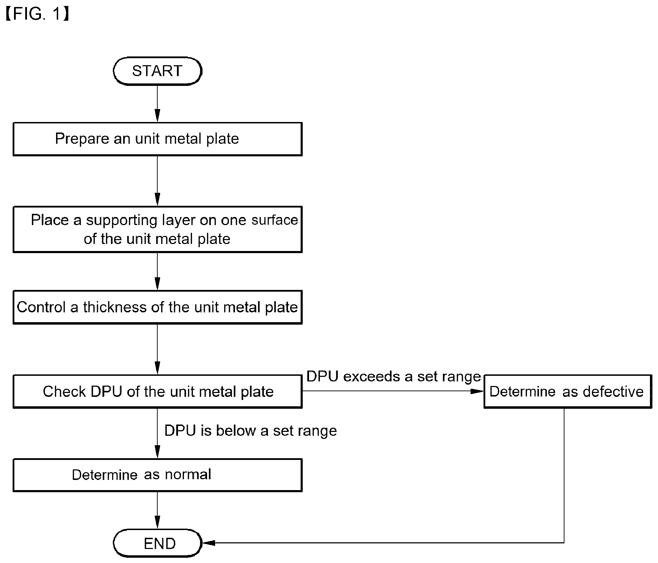

Referring to FIGS. 1 to 5, a metal plate according to an embodiment and a test method thereof are described.

### Metal plate and test method thereof

The metal plate 10 according to the embodiment is a raw material for manufacturing the deposition mask according to the embodiment. That is, the deposition mask is formed by forming a plurality of through holes in the metal plate 10.

Referring to FIG. 1, the test method includes a first step of preparing a unit metal plate, a second step of arranging a supporting layer on one surface of the unit metal plate, a third step of controlling a thickness of the unit metal plate, a fourth step of checking a DPU (Defect Per Unit) of the unit metal plate, and a fifth step of determining the unit metal plate.

Referring to FIGS. 1 to 3, in the first step, a metal plate having a set size is prepared.

The metal plate 10 includes a first surface 1S and a second surface 2S opposite to the first surface 1S. In addition, the metal plate 10 has a set size.

The metal plate 10 is disposed in a state of being wound on a roller for a roll-to-roll process. In the first step, a unit metal plate having a set size is cut from the roller.

The unit metal plate 10 has a set thickness. For example, the thickness (T) of the unit metal plate 10 may be 100 µm or less. In detail, the thickness (T) of the unit metal plate 10 may be 15 µm to 100 µm or 60 µm to 80 µm. The thickness (T) of the unit metal plate 10 is defined as a maximum distance from the first surface 1S to the second surface 2S.

In addition, the unit metal plate 10 has a set width (W) and length (L). For example, the length (L) of the unit metal plate 10 may be 900 mm to 1100 mm. The width (W) of the unit metal plate 10 may be 290 mm to 300 mm.

The metal plate includes an alloy. Specifically, the metal plate includes iron (Fe) and nickel (Ni). More specifically, the metal plate includes iron (Fe), nickel (Ni), oxygen (O), and chromium (Cr). In addition, the metal plate may further include a small amount of at least one element among carbon (C), silicon (Si), sulfur (S), phosphorus (P), manganese (Mn), titanium (Ti), cobalt (Co), copper (Cu), silver (Ag), vanadium (V), niobium (Nb), indium (In), and antimony (Sb). As an example, the metal plate may include an invar alloy.

The invar is an alloy including iron and nickel. The Invar is an alloy whose coefficient of thermal expansion is close to 0. Since the Invar has a very small coefficient of thermal expansion, the invar is used for precision parts such as masks. Therefore, a deposition mask manufactured using the unit metal plate 10 has improved reliability. That is, deformation of the deposition mask is prevented. In addition, a life of the deposition mask is increased.

The metal plate may contain about 60 wt% to about 65 wt% of the iron. In addition, the metal plate may contain about 35 wt% to about 40 wt% of the nickel. In detail, the metal plate contains about 63.5 wt% to about 64.5 wt% of the iron and about 35.5 wt% to about 36.5 wt% of the nickel. In addition, the metal plate may include at least one element among carbon (C), silicon (Si), sulfur (S), phosphorus (P), manganese (Mn), titanium (Ti), cobalt (Co), copper (Cu), silver (Ag), vanadium (V), niobium (Nb), indium (In), and antimony (Sb) at about 1 wt% or less.

The components, content, and wt% of the metal plate can be confirmed by sampling a specimen. In detail, a specific region is selected on a plane of the metal plate 10. Then, a specimen corresponding to the thickness of the metal plate 10 is sampled. Then, the specimen is dissolved in a strong acid to confirm the wt% of each component. However, the embodiment is not limited thereto. The wt% of the composition can be confirmed by various methods that can confirm the composition of the metal plate.

The metal plate includes various elements in addition to iron and nickel. Accordingly, the metal plate includes inclusions having various compositions, composition ratios, and sizes. A through hole is formed in the metal plate. If a number of the inclusions is large or a size of the inclusions is large, a defect in the through hole may occur.

Therefore, the test method of the metal plate confirms the size and number of the inclusions in advance. Therefore, the metal plate capable of manufacturing the deposition mask can be selected in advance. Alternatively, after manufacturing the deposition mask, a defect rate of the through hole according to the size and number of the inclusions can be predicted.

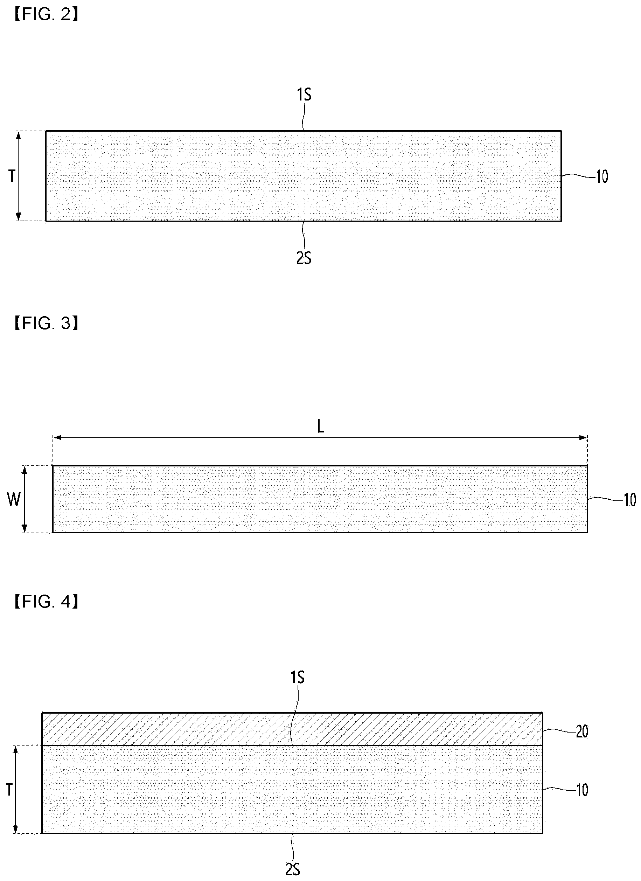

Referring to FIG. 1 and FIG. 4, in the second step, a supporting layer 20 is disposed on the first surface 1S or the second surface 2S. For example, the supporting layer 20 is formed by rolling a roller on the first surface 1S. Thus, the supporting layer 20 is disposed on the first surface 1S.

The supporting layer 20 may include a resin material. In addition, the supporting layer 20 may be transparent. In detail, the supporting layer 20 includes a light-transmitting material.

When etching the unit metal plate 10, the unit metal plate 10 is supported by the supporting layer 20. In addition, when irradiating light to the unit metal plate, the supporting layer 20 can transmit light. This will be described below.

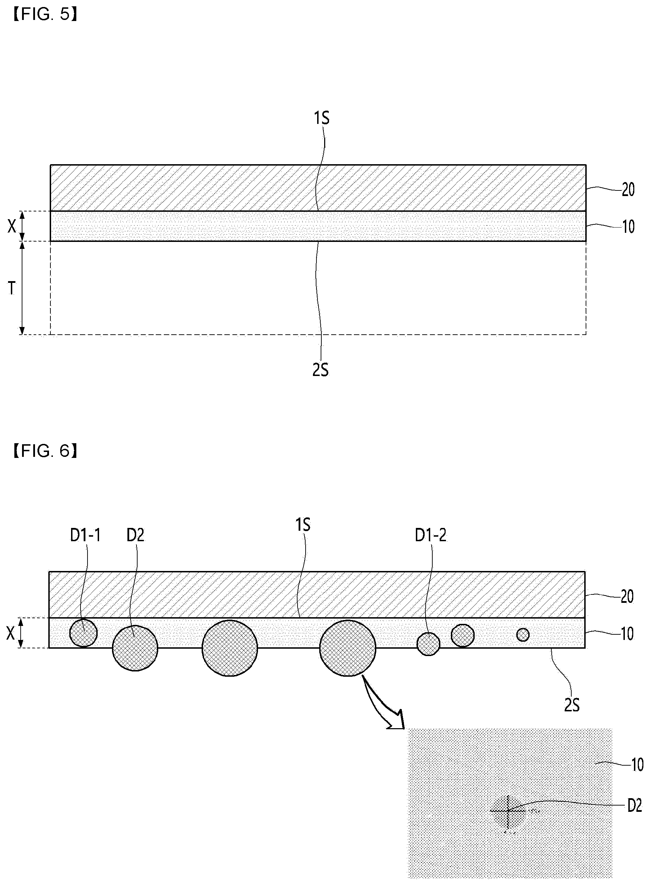

Referring to FIG. 1 and FIG. 5, in the third step, a thickness of the unit metal plate 10 is reduced to a set thickness. In detail, the unit metal plate 10 is etched. Accordingly, a thickness of the unit metal plate 10 is controlled. Accordingly, a thickness of the unit metal plate 10 is changed to a test thickness (X).

For example, in the third step, the thickness of the unit metal plate 10 is changed from an initial thickness (T) to a test thickness (X). The test thickness (X) is a thickness after etching the unit metal plate 10.

For example, when the supporting layer 20 is disposed on the first surface 1S, the second surface 2S is etched.

The thickness of the unit metal plate 10 can be controlled by various processes. For example, the unit metal plate 10 can be etched by a wet etching process. In detail, the unit metal plate 10 can be etched with an acidic etchant.

The etchant can etch the invar metal. The etchant can include a ferric chloride solution. Alternatively, the etchant can include a solution in which at least one of perchloric acid, hydrochloric acid, sulfuric acid, formic acid, and acetic acid is mixed with a ferric chloride solution.

The unit metal plate 10 can be immersed in the etchant. Alternatively, the etchant can be sprayed on the second surface 2S. That is, the unit metal plate 10 can be etched by a dipping process or a spraying process.

Accordingly, the thickness of the unit metal plate 10 is adjusted to a set thickness range. In detail, the unit metal plate 10 is adjusted to a test thickness (X) of X µm. The X may be 3µm to 10µm.

Before etching the unit metal plate 10, the metal plate may be rolled. A rolling process is optionally performed.

For example, the unit metal plate 10 is subjected to a cold rolling process. Accordingly, the thickness of the unit metal plate 10 is formed to be about 30µm or less. Subsequently, an etching process may be performed.

After controlling the thickness of the unit metal plate 10, an unit size of the unit metal plate is defined by the thickness, length, and width of the unit metal plate 10. In detail, the unit size is defined as length*width*test thickness (L*W*X). The unit size can correspond to a size of at least one deposition mask manufactured by the unit metal plate 10. That is, one or more deposition masks can be manufactured using the unit metal plate 10. The unit size is used when checking the DPU (Defect Per Unit) of the metal plate described below.

Next, referring to FIGS. 6 to 9, in the fourth step, the size and number of inclusions of the unit metal plate 10 are checked. The inclusion includes at least one element among carbon, oxygen, magnesium, aluminum, silicon, sulfur, calcium, and iron. That is, the fourth step checks the DPU. The DPU is a number of inclusions per unit size of the unit metal plate.

Referring to FIG. 6, when the X is adjusted to a range of 3 µm to 10 µm, most of the inclusions whose maximum size is X µm or less remain. For example, an inclusion having a maximum size of X µm or less may include a first-first inclusion D1-1 and a first-second inclusion D1-2. The first-first inclusion D1-1 may remain. In addition, the first-second inclusion D1-2 may protrude out of the second surface 2S.

In addition, a second inclusion D2 having a maximum size exceeding X µm may be included. The second inclusion D2 protrudes out of the unit metal plate 10. Accordingly, the second inclusion D2 protrudes out of the second surface 2S.

That is, the test thickness varies depending on a size of the inclusion being measured. For example, when checking the number of inclusions exceeding 10µm, the thickness (X) is controlled to 10µm. Alternatively, when the number of inclusions exceeding 3µm is confirmed, the thickness (X) is controlled to 3µm.

That is, the DPU (Defect Per Unit) is defined as an inclusion having a size exceeding the thickness of the unit metal plate. That is, the size of the inclusion is larger than the thickness of the unit metal plate.

In addition, the inclusion is related to a height (step height) of a small-surface hole V1 of the deposition mask. In detail, a small-surface hole V1 is formed at one surface of the unit metal plate, and a large-surface hole V2 is formed at an other surface. The small-surface hole V1 and the large-surface hole V2 are connected by a connection portion CA to form a through hole. The height (step height) of the small-surface hole V1 is a vertical distance from one surface of the metal plate to the connection portion. The size of the inclusion is greater than or equal to the height (step height) of the small-surface hole V1.

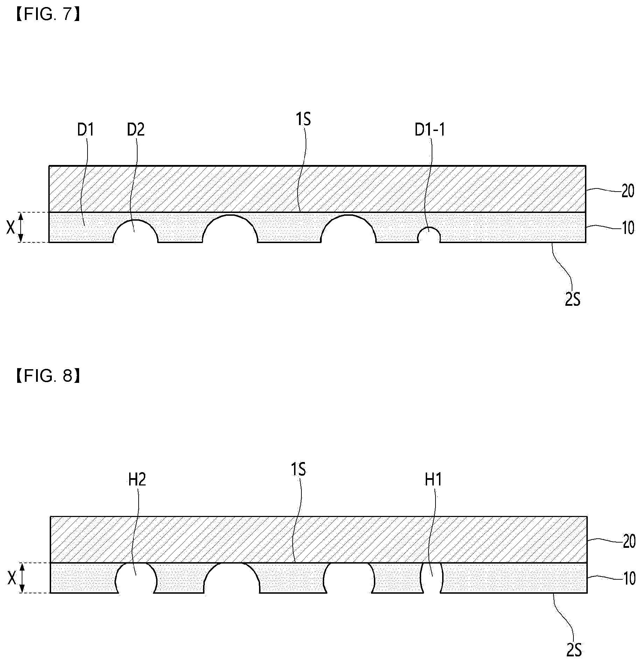

Referring to FIG. 7, the inclusion protruding outwardly from the second surface 2S can come outwardly from the unit metal plate 10. The inclusion and the unit metal plate 10 form crevice corrosion. The first-first inclusion D1-1 and the second inclusion D2 come outwardly from the unit metal plate 10 due to the crevice corrosion.

Accordingly, referring to FIG. 8, a surface hole is formed in a region from which the first-first inclusion D1-1 and the second inclusion D2 come out. For example, the unit metal plate 10 includes a first surface hole H1 and a second surface hole H2. The first surface hole H1 is a region from which the first-first inclusion D1-1 comes out. The second surface hole H2 is a region from which the second inclusion D2 comes out.

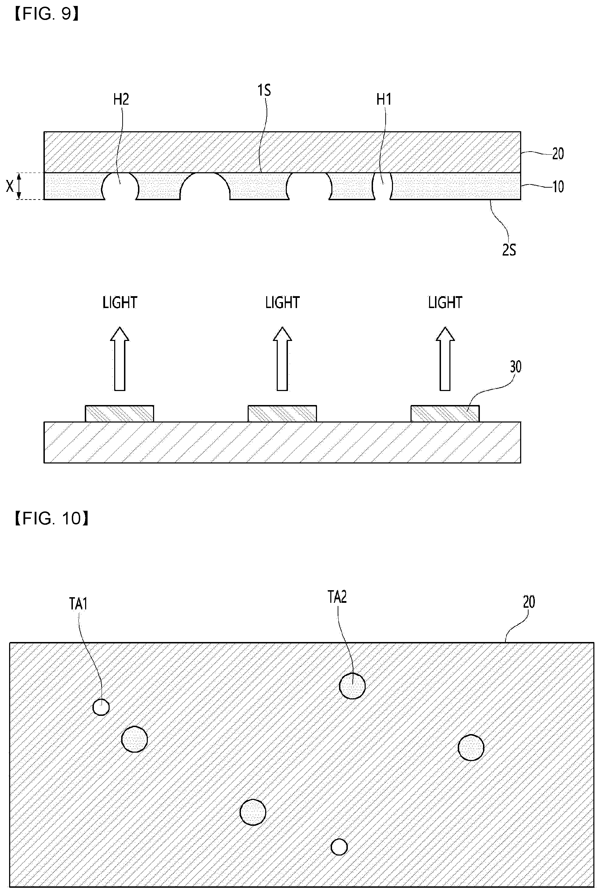

Referring to FIG. 9, a light source 30 is disposed under the second surface 2S. Then, light is irradiated to the second surface 2S. The light of the light source 30 can move from the second surface 2S to the first surface 1S.

The DPU (Defect Per Unit) can be confirmed by the light projected from the supporting layer 20.

In detail, the light incident on the first surface hole H1 and the second surface hole H2 passes through the supporting layer 20. In addition, the light incident on a region other than the surface hole of the unit metal plate 10 does not pass through the unit metal plate 10.

Referring to FIG. 10, the light passing through the first surface hole H1 and the second surface hole H2 can be confirmed on the supporting layer 20. In detail, a first transmission region TA1 and a second transmission region TA2 can be confirmed on the supporting layer 20. The first transmission region TA1 is a region that has passed through the first surface hole H1. The second transmission region TA2 is a region that has passed through the second surface hole H2. The first transmission region TA1 and the second transmission region TA2 have different sizes.

The DPU (Defect Per Unit) is confirmed by a number of the second transmission region TA2. That is, the first transmission region TA1 is a region that has passed through the first surface H1 formed by the first inclusion. When confirming the number of DPU (Defect Per Unit), a number of the first transmission region TA1 is excluded.

Next, referring to FIG. 1, in the fifth step, whether the unit metal plate 10 is normal or defective is determined by the DPU (Defect Per Unit). That is, if the number of the second transmission region for the unit size (L*W*X) is less than or equal to a set range, the unit metal plate 10 is determined as normal.

In addition, if a number of the second transmission region for the unit size (L*W*X) of the metal plate is greater than or equal to a set range, the unit metal plate 10 is determined as a defect.

For example, the unit metal plate 10 may have a length (L) of 900 mm to 1100 mm, a width (W) of 290 mm to 300 mm, and a thickness (X) of 3 µm to 10 µm. If the number of the DPU (Defect Per Unit) of the unit size (L*W*X) of the metal plate is 10 or less, it is determined as normal. In detail, if the number of DPU (Defect Per Unit) of the unit size (L*W*X) of the metal plate is 0 or more and 10 or less, or 1 or more and 10 or less, it is determined as normal. In addition, if the number of DPU exceeds 10, it is determined as a defect.

In detail, the metal plate 10 may have a length (L) of 900 mm to 1100 mm, a width (W) of 290 mm to 300 mm, and a thickness (X) of 3 µm to 10 µm. If the number of inclusions having a size exceeding the thickness (X) of the unit metal plate 10 is 10 or less, it is determined as normal. In addition, if the number of inclusions having a size exceeding the thickness (X) of the unit metal plate 10 exceeds 10, it is determined as a defect.

In detail, if the deposition mask is manufactured with the metal plate having the DPU (Defect Per Unit) of 10 or less, a defect of the through hole formed in the metal plate 10 can be minimized. However, if the deposition mask is manufactured with the metal plate having the DPU (Defect Per Unit) of more than 10, a size or a shape of the through hole formed in the metal plate 10 may change. Accordingly, a quality of a deposition pattern formed by the deposition mask may decrease.

### Example 1

A unit metal plate having a length (L) of 900 mm, a width (W) of 290 mm, and a thickness (X) of 3 µm to 10 µm is manufactured. Then, a number of the DPU is measured by a test method of the metal plate.

Next, three deposition masks are manufactured using the unit metal plate. At this time, 70 million through holes are formed in each deposition mask.

Next, a defect of the through hole according to the number of DPU (Defect Per Unit) in one deposition mask is confirmed. The inclusion of the DPU (Defect Per Unit) is an inclusion having a size exceeding the thickness (X) of the unit metal plate.

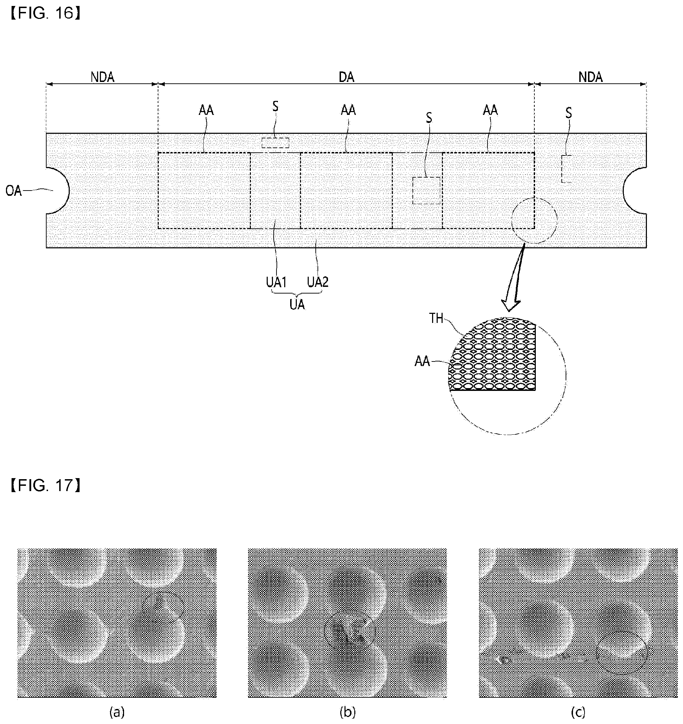

In addition, a defect of the through hole is as shown in FIG. 17. For example, as in (a) of FIG. 17, a through hole having a larger diameter than other through holes is determined as a defect. As in (b) of FIG. 17, through holes that are connected to each other are determined as a defect. As in (c) of FIG. 17, a through hole having a smaller diameter than other through holes is determined as a defect.

### Example 2

A unit metal plate having a length (L) of 1000 mm, a width (W) of 300 mm, and a thickness (X) of 3 µm to 10 µm is manufactured. Then, the number of DPUs is measured using the test method of the metal plate. Then, the defects of the through holes of the deposition mask are confirmed in a same manner as in Example 1.

### Example 3

A unit metal plate having a length (L) of 1100 mm, a width (W) of 310 mm, and a thickness (X) of 3 µm to 10 µm is manufactured. Then, the number of DPUs is measured using the test method of the metal plate. Then, the defects of the through holes of the deposition mask are confirmed in a same manner as in Example 1.

**[Table 1]**

| Experimental example | Thickness (X, µm) | NUMBER OF DPU | through hole defect rate (%) (Defective through hole/Total through |
|---|---|---|---|
| | | | hole*100) |
| 1 | 3 | 3 | 0.000002% |
| 2 | 3 | 20 | 0.000015% |
| 3 | 4 | 9 | 0.000005% |
| 4 | 4 | 14 | 0.00001% |
| 5 | 5 | 7 | 0.000003% |
| 6 | 5 | 11 | 0.000006% |
| 7 | 6 | 6 | 0.000002% |
| 8 | 6 | 12 | 0.000007% |
| 9 | 7 | 1 | 0.000001% |
| 10 | 7 | 46 | 0.000049% |
| 11 | 8 | 5 | 0.000003% |
| 12 | 8 | 19 | 0.00001% |
| 13 | 9 | 7 | 0.000004% |
| 14 | 9 | 20 | 0.000012% |
| 15 | 10 | 6 | 0.0000035% |
| 16 | 10 | 14 | 0.000008% |

**[Table 2]**

| Experime ntal example | Thickness(X, µm) | NUMBER OF DPU | through hole defect rate (%) (Defective through hole/Total through hole*100) |
|---|---|---|---|
| 1 | 3 | 8 | 0.000004% |
| 2 | 3 | 30 | 0.000023% |
| 3 | 4 | 10 | 0.000005% |
| 4 | 4 | 18 | 0.000013% |
| 5 | 5 | 7 | 0.000004% |
| 6 | 5 | 13 | 0.000011% |
| 7 | 6 | 5 | 0.000003% |
| 8 | 6 | 25 | 0.000021% |
| 9 | 7 | 1 | 0.000001% |
| 10 | 7 | 24 | 0.000021% |
| 11 | 8 | 9 | 0.000005% |
| 12 | 8 | 31 | 0.000026% |
| 13 | 9 | 6 | 0.000003% |
| 14 | 9 | 11 | 0.000006% |
| 15 | 10 | 5 | 0.000002% |
| 16 | 10 | 24 | 0.000027% |

**[Table 3]**

| Experime ntal example | Thickness(X, µm) | NUMBER OF DPU | through hole defect rate (%) (Defective through hole/Total through hole*100) |
|---|---|---|---|
| 1 | 3 | 2 | 0.000001% |
| 2 | 3 | 41 | 0.000031% |
| 3 | 4 | 8 | 0.0000035% |
| 4 | 4 | 22 | 0.000021% |
| 5 | 5 | 9 | 0.000005% |
| 6 | 5 | 32 | 0.000025% |
| 7 | 6 | 1 | 0.000001% |
| 8 | 6 | 17 | 0.000008% |
| 9 | 7 | 3 | 0.000002% |
| 10 | 7 | 20 | 0.000009% |
| 11 | 8 | 5 | 0.000002% |
| 12 | 8 | 19 | 0.000009% |
| 13 | 9 | 2 | 0.000001% |
| 14 | 9 | 12 | 0.000007% |
| 15 | 10 | 6 | 0.0000024% |
| 16 | 10 | 29 | 0.000009% |

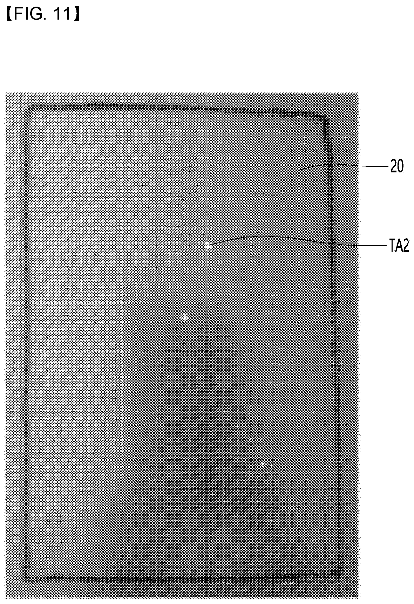

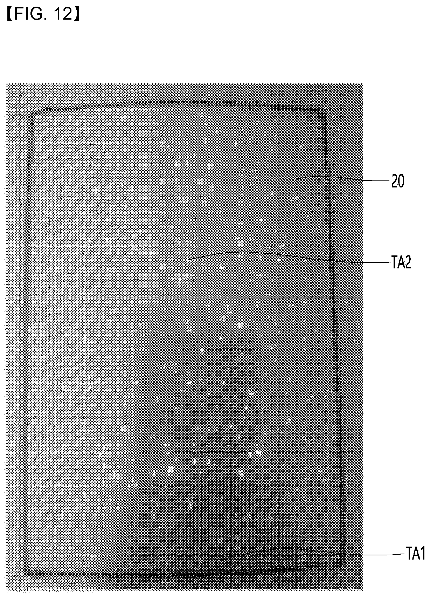

Table 1 shows results according to Example 1. Table 2 shows results according to Example 2. Table 3 shows results according to Example 3. In addition, FIG. 11 is a photograph of Experimental Example 9 of Example 1. FIG. 12 is a photograph of Experimental Example 10 of Example 1.

Referring to Tables 1 to 3, it can be seen that when the number of inclusions exceeding the thickness of the unit metal plate exceeds 10, a through-hole defect rate significantly increases.

The embodiment controls the DPU (Defect Per Unit) of the unit metal plate within a set range. Therefore, the defect of the through-hole of the deposition mask manufactured with the unit metal plate is reduced. Therefore, the deposition mask manufactured with the unit metal plate has improved deposition quality and deposition reliability.

In addition, the normality and defect of the unit metal plate can be confirmed in advance before manufacturing the deposition mask. Therefore, the process of manufacturing the deposition mask with the unit metal plate that has received a defect determination is prevented. Therefore, the process efficiency is improved.

### Deposition mask

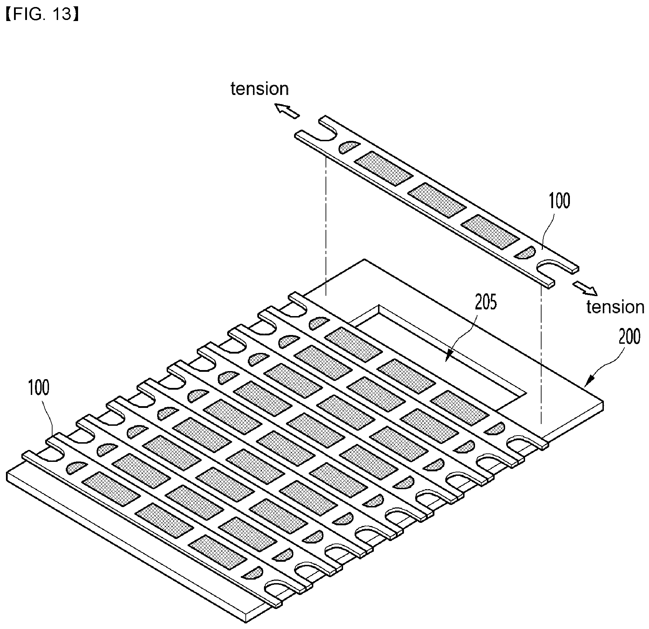

Hereinafter, a deposition mask according to an embodiment will be described with reference to FIGS. 13 to 15.

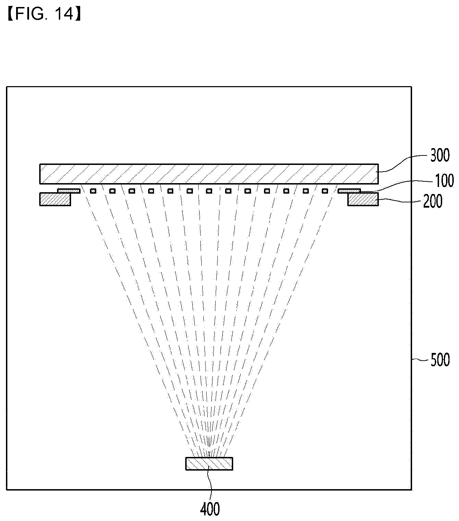

Referring to FIGS. 13 and 14, an organic deposition device includes a deposition mask 100, a mask frame 200, a deposition substrate 300, an organic deposition container 400, and a vacuum chamber 500.

The deposition mask 100 is formed by the metal plate 10 described above. The deposition mask 100 includes a plurality of through holes TH. The through holes are disposed in an effective portion. The through holes are disposed to correspond to a pixel pattern to be formed on a deposition substrate.

The mask frame 200 includes an opening 205. The plurality of through holes are disposed on a region corresponding to the opening 205. Accordingly, an organic material supplied to the organic deposition container 400 is deposited on the deposition substrate 300. The deposition mask 100 is disposed and fixed on the mask frame 200. For example, the deposition mask 100 is tensioned with a constant tensile force. In addition, the deposition mask 100 is welded and fixed on the mask frame 200.

For example, an ineffective region of the deposition mask 100 is welded. As a result, the deposition mask 100 is fixed on the mask frame 200. Then, a portion protruding outward from the mask frame 200 is cut and removed.

The mask frame 200 includes a metal having high rigidity. As a result, deformation of the mask frame is reduced during a welding process.

The deposition substrate 300 is a substrate used when manufacturing a display device. For example, an OLED pixel pattern is formed on the deposition substrate 300. On the deposition substrate 300, organic patterns of red, green, and blue are formed to form pixels, which are three primary colors of light. That is, an RGB pattern is formed on the deposition substrate 300.

The organic deposition container 400 is a crucible. An organic material is disposed inside the crucible. The organic deposition container 400 moves within the vacuum chamber 500. That is, the organic deposition container 400 moves in one direction within the vacuum chamber 500. For example, the organic deposition container 400 moves in a width direction of the deposition mask 100 within the vacuum chamber 500.

A heat source and/or current is supplied to the organic deposition container 400. As a result, the organic material is deposited on the deposition substrate 300.

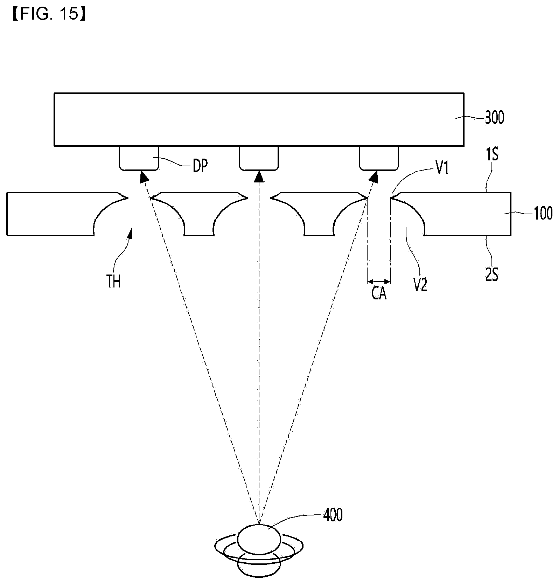

Referring to FIG. 15, the deposition mask 100 includes a first surface 1S and a second surface 2S opposite to the first surface.

The first surface 1S includes a small-surface hole V1. The second surface 2S includes a large-surface hole V2. For example, a plurality of small-surface holes V1 and a plurality of large-surface holes V2 are formed on the first surface 1S and the second surface 2S, respectively.

In addition, the deposition mask 100 includes a through hole TH. The through hole TH is formed by a connection portion CA connecting boundaries of the small-surface hole V1 and the large-surface hole V2.

A width of the large-surface hole V2 is larger than a width of the small-surface hole V1. The width of the small-surface hole V1 is measured at the first surface 1S of the deposition mask 100. The width of the large-surface hole V2 is measured at the second surface 2S of the deposition mask 100.

In addition, a width of the connection portion CA has a set size. In detail, the width of the connection portion CA may be 15 µm to 33 µm. In more detail, the width of the connection portion CA may be 19 µm to 33 µm. In more detail, the width of the connection portion CA may be 20 µm to 27 µm. If the width of the connection portion CA exceeds 33 µm, it is difficult to implement a resolution of 500 PPI or higher. In addition, if the width of the connection portion CA is less than 15 µm, a defect may occur during a deposition process.

The small-surface hole V1 faces the deposition substrate 300. The small-surface hole V1 is disposed close to the deposition substrate 300. Accordingly, the small-surface hole V1 has a shape corresponding to the deposition pattern DP.

The large-surface hole V2 faces the organic material deposition container 400. Accordingly, the organic material supplied from the organic material deposition container 400 can be accommodated in a wide width by the large-surface hole V2. In addition, a fine pattern can be quickly formed on the deposition substrate 300 through the small-surface hole V1.

Accordingly, the organic material accommodated by the large-surface hole V1 is deposited on the deposition substrate 300 by the small-surface hole V1. Accordingly, one of the red, green or blue pixel patterns is formed on the deposition substrate 300. Subsequently, the process is repeated. Accordingly, all of the red, green or blue pixel patterns are formed on the deposition substrate 300.

Referring to FIG. 16, the deposition mask 100 according to the embodiment includes a deposition region DA and a non-deposition region NDA.

The deposition region DA is a region for forming a deposition pattern. The deposition region DA includes an effective region AA and an ineffective region UA. The effective region AA is a region in which a through hole TH through which the organic material passes is formed. In addition, the ineffective region UA is a region in which the through hole TH is not formed. In addition, the through hole TH may be formed in the ineffective region UA. However, the through hole TH of the ineffective region UA does not allow the organic material to pass therethrough.

In the drawing, the effective region AA is illustrated as a square shape. However, the embodiment is not limited thereto. The effective region AA may have a rectangular shape or a circular shape.

The effective region AA includes a plurality of effective regions. The plurality of effective regions are spaced apart in the first direction.

The deposition region DA may be a region from a point where a first effective region starts in the first direction to a point where a last effective region ends.

In addition, the deposition region DA may be a region from a point where a first ineffective region starts in the first direction to a point where a last ineffective region ends.

The ineffective region UA is a deposition region other than the effective region AA. The ineffective region UA can be divided into a first ineffective region UA1 and a second ineffective region UA2 according to a location.

The first ineffective region UA1 is a region between the effective region AA. Accordingly, a plurality of first ineffective regions UA1 are spaced apart in the first direction. In addition, the second ineffective region UA2 is a region between the effective region AA and both ends in the second direction.

The non-deposition region NDA is a region that does not participate in deposition. The non-deposition region NDA includes a frame fixing region. The frame fixing region is a region for fixing the deposition mask 100 to the mask frame 200. In addition, the non-deposition region NDA may include at least one of a half-etching portion and an open portion OA. The half-etching portion HF is formed by partially etching the metal plate 10. The open portion OA is formed by entirely etching the metal plate 10.

Residual stress generated when the deposition mask 100 is tensioned is dispersed by the half-etched portion HF. Accordingly, a waviness of the deposition mask is reduced.

In addition, a jig such as a clamp used when tensioning the deposition mask 100 is fixed to the open portion OP.

A through hole TH is disposed in the effective region AA. In detail, a through hole TH including the small-surface hole V1, the large-surface hole V2, and the small-surface hole V1 and the connection portion CA is disposed in the effective region AA.

The deposition mask 100 can have a DPU (Defect Per Unit) within a set range.

The DPU (Defect Per Unit) of the deposition mask 100 can be confirmed by sampling a specimen. In detail, a specific region (length (a) * width (b)) on a plane of the deposition mask 100 is selected. Then, a specimen (a * b * t1) corresponding to a thickness (t1) of the deposition mask 100 is sampled. Then, the DPU (Defect Per Unit) is confirmed by the test method. In detail, a supporting layer is disposed on one surface of the specimen. Then, the other surface of the specimen is etched to adjust the thickness of the specimen to the test thickness (t2). Then, light is irradiated on the specimen to confirm the DPU (Defect Per Unit).

The DPU (Defect Per Unit) of the deposition mask is a number of inclusions having a set size per size of the specimen. In detail, the DPU (Defect Per Unit) is a number of inclusions having a size exceeding the test thickness (t2) per size of the specimen. The test thickness (t2) may be 3 µm to 10 µm.

For example, the specimen (S) can be sampled as 30mm*60mm*t1 (first specimen), 60mm*30mm*t1 (second specimen), or 60mm*60mm*t1 (third specimen).

The specimen (S) can be sampled from various regions of the deposition mask 100. In detail, the specimen (S) can be sampled from at least one region among the non-deposition region NDA, the first ineffective region UA1, and the second ineffective region UA2.

The DPU (Defect Per Unit) of the deposition mask can vary depending on a size of the specimen (S). In detail, when the size of the specimen is 30mm*60mm*t1 or 60mm*30mm*t1, the DPU (Defect Per Unit) can be 1 or less. In addition, when the size of the specimen is 60mm*60mm*t1, the DPU(Defect Per Unit) may be 3 or less.

If the number of the DPU(Defect Per Unit) exceeds the above range, the defect of the through hole may increase. Accordingly, the quality of the deposition pattern formed on the deposition substrate decreases.

### Example 4

A deposition region and a non-deposition region are defined on a metal plate having a length of 330mm, a width of 100mm, and a thickness of 25µm. Then, a plurality of through holes are formed in the deposition region to manufacture a deposition mask. The through holes are formed in numbers of about 70 million.

Then, the DPU is measured using the test method.

In detail, a specimen of 30mm*60mm*t1 (length*width*thickness) is sampled from the non-deposition region of the deposition mask. Then, a supporting layer is disposed on one surface of the specimen. In addition, the thickness of the specimen is controlled on the other surface of the specimen. In detail, the thickness of the specimen is controlled to the test thickness (t2). Then, light is irradiated from a lower side of the other surface of the specimen. Then, the number of DPUs is measured by the size and number of light-transmitting regions transmitted through the supporting layer. At this time, the test thickness (t2) is 3 µm to 10 µm.

Then, the presence or absence of a defect in the through hole is checked according to the DPU (Defect Per Unit). The size of the inclusion of the DPU (Defect Per Unit) exceeds the test thickness (t2) of the specimen.

In addition, the defect in the through hole is as shown in FIG. 17.

### Example 5

A deposition mask is manufactured using a metal plate having a length of 340 mm, a width of 100 mm, and a thickness of 20 µm. A specimen of 60 mm*30 mm*t1 (length*width*thickness) is sampled from the ineffective region of the deposition region of the deposition mask. No through holes are formed in the ineffective region. The number of DPUs of the deposition mask is measured using the specimen. Then, the presence of defects in the through holes of the deposition mask is checked in a same manner as in Example 4.

### Example 6

A deposition mask is manufactured using a metal plate having a length of 320 mm, a width of 100 mm, and a thickness of 30 µm. A specimen of 60 mm*60 mm*t1 (length*width*thickness) is sampled from the ineffective region of the deposition region of the deposition mask. No through holes are formed in the ineffective region. The number of DPUs of the deposition mask is measured using the specimen. Then, the presence of defects in the through holes of the deposition mask is checked in a same manner as in Example 4.

**[Table 4]**

| Experimental example | Test thickness (t2, µm) | NUMBER OF DPU | through hole defect rate (%) (Defective through hole/Total through hole*100) |
|---|---|---|---|
| 1 | 3 | 0 | 0.000001% |
| 2 | 3 | 3 | 0.000008% |
| 3 | 4 | 1 | 0.000002% |
| 4 | 4 | 2 | 0.000011% |
| 5 | 5 | 1 | 0.000002% |
| 6 | 5 | 4 | 0.000015% |
| 7 | 6 | 1 | 0.000004% |
| 8 | 6 | 3 | 0.000008% |
| 9 | 7 | 0 | 0.000002% |
| 10 | 7 | 5 | 0.000023% |
| 11 | 8 | 1 | 0.000003% |
| 12 | 8 | 3 | 0.000015% |
| 13 | 9 | 1 | 0.000001% |
| 14 | 9 | 7 | 0.000033% |
| 15 | 10 | 0 | 0.000002% |
| 16 | 10 | 4 | 0.000022% |

**[Table 5]**

| Experimental example | Test thickness (t2, µm) | NUMBER OF DPU | through hole defect rate (%) (Defective through hole/Total through hole*100) |
|---|---|---|---|
| 1 | 3 | 1 | 0.000001% |
| 2 | 3 | 2 | 0.000009% |
| 3 | 4 | 1 | 0.000003% |
| 4 | 4 | 8 | 0.000027% |
| 5 | 5 | 0 | 0.000001% |
| 6 | 5 | 3 | 0.000009% |
| 7 | 6 | 1 | 0.000002% |
| 8 | 6 | 7 | 0.000015% |
| 9 | 7 | 0 | 0.000002% |
| 10 | 7 | 6 | 0.000023% |
| 11 | 8 | 0 | 0.000001% |
| 12 | 8 | 3 | 0.000015% |
| 13 | 9 | 1 | 0.000004% |
| 14 | 9 | 5 | 0.000016% |
| 15 | 10 | 1 | 0.000005% |
| 16 | 10 | 6 | 0.000029% |

**[Table 6]**

| Experimental example | Test thickness (t2, µm) | NUMBER OF DPU | through hole defect rate (%) (Defective through hole/Total through hole*100) |
|---|---|---|---|
| 1 | 3 | 0 | 0.000001% |
| 2 | 3 | 6 | 0.000024% |
| 3 | 4 | 1 | 0.000003% |
| 4 | 4 | 4 | 0.000011% |
| 5 | 5 | 1 | 0.000002% |
| 6 | 5 | 5 | 0.000014% |
| 7 | 6 | 0 | 0.000001% |
| 8 | 6 | 2 | 0.000007% |
| 9 | 7 | 1 | 0.000005% |
| 10 | 7 | 7 | 0.000034% |
| 11 | 8 | 1 | 0.000004% |
| 12 | 8 | 2 | 0.000009% |
| 13 | 9 | 0 | 0.000001% |
| 14 | 9 | 3 | 0.000014% |
| 15 | 10 | 0 | 0.000002% |
| 16 | 10 | 8 | 0.000041% |

Table 4 shows results according to Example 4. Table 5 shows results according to Example 5. Table 6 shows results according to Example 6. Referring to Tables 4 and 5, when the DPU (Defect Per Unit) of the deposition mask exceeds 1, the through-hole defect rate significantly increases. In addition, referring to Table 6, when the DPU (Defect Per Unit) of the deposition mask exceeds 3, the through-hole defect rate significantly increases.

Therefore, the embodiment controls the DPU (Defect Per Unit) within a set range. Accordingly, the defect of the through hole is reduced. Therefore, the deposition mask has improved deposition quality and deposition reliability.

In addition, after manufacturing the deposition mask, the deposition quality and deposition reliability of the deposition mask can be confirmed in advance by the size of the DPU (Defect Per Unit). Therefore, only the deposition mask having a small defect rate of the through hole can be selectively selected and the deposition process can be performed. Therefore, the efficiency of the deposition process is improved.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A metal plate having a length (L) of 900 mm to 1,100 mm, a width (W) of 290 mm to 300 mm, and a thickness (T) of 15 µm to 100 µm, the metal plate comprising:
wherein the metal plate includes invar,
wherein the thickness of the metal plate is adjusted to a test thickness (X) of 3 µm to 10 µm to form a unit metal plate having a unit size of L*W*X,
wherein a number of inclusions per unit size of the unit metal plate is 10 or less, and
wherein the inclusion has a size exceeding the test thickness.

2. The metal plate of claim 1, wherein the inclusion includes at least one element among a carbon element, an oxygen element, a magnesium element, an aluminum element, a silicon element, a sulfur element, a calcium element, and an iron element.

3. A deposition mask comprising:
a deposition region and a non-deposition region,
wherein the deposition region includes an effective region in which a through hole is formed and an ineffective region other than the effective region,
wherein the through hole is formed by a small-surface hole; a large-surface hole; and a communication portion communicating the small-surface hole and the large-surface hole,
wherein a first specimen of 30mm (length) * 60mm (width) * t1 (thickness) is sampled from at least one region among the ineffective region and the non-deposition region, and
wherein when the thickness of the first specimen is adjusted to a test thickness (t2), a number of inclusions in the first specimen having a size exceeding the test thickness is 1 or less.

4. The deposition mask of claim 3, wherein the inclusion includes at least one element among a carbon element, an oxygen element, a magnesium element, an aluminum element, a silicon element, a sulfur element, a calcium element, and an iron element.

5. The deposition mask of claim 4, wherein a second specimen of 60mm(length)*30mm(width)*t1(thickness) is sampled from at least one region among the ineffective region and the non-deposition region, and
wherein when the thickness of the second specimen is adjusted to the test thickness (t2), a number of inclusions in the second specimen having a size exceeding the test thickness is 1 or less.

6. The deposition mask of claim 4, wherein a third specimen of 60mm(length)*60mm(width)*t1(thickness) is sampled from at least one region among the ineffective region and the non-deposition region, and
wherein when the thickness of the third specimen is adjusted to the test thickness (t2), a number of inclusions in the third specimen having a size exceeding the test thickness is 3 or less.

7. A test method comprising:
preparing a unit metal plate;
placing a supporting layer on one surface of the unit metal plate;
controlling a thickness of the unit metal plate;
checking a DPU (Defect Per Unit) of the unit metal plate; and
determining the unit metal plate,
wherein the checking the DPU (Defect Per Unit) of the unit metal plate comprises checking a number of inclusions of the unit metal plate by irradiating light onto the unit metal plate.

8. The test method of claim 7, wherein the controlling the thickness of the unit metal plate includes changing the thickness of the unit metal plate to a test thickness of 3 µm to 10 µm, and
wherein the inclusion has a size exceeding the test thickness.

9. The test method of claim 8, wherein when the light is irradiated onto the unit metal plate, a first transmission region having a size less than the test thickness and a second transmission region having a size exceeding the test thickness are formed on the supporting layer, and
wherein the inclusion is checked by a number of the second transmission regions.

10. The test method of claim 7, wherein the inclusion includes at least one element among a carbon element, an oxygen element, a magnesium element, an aluminum element, a silicon element, a sulfur element, a calcium element, and an iron element.
